# EUROPÄISCHE PATENTSCHRIFT

(11) **EP 0 497 198 B1**
(45) Veröffentlichungstag und Bekanntmachung des Hinweises auf die Patenterteilung: **27.12.1995**
(21) Anmeldenummer: 92100981.7
(22) Anmeldetag: 22.01.1992
(51) Int. Cl.: H05K 7/14

(54) **Quaderförmiges Gehäuse für eine elektronische Einrichtung mit Steckverbindungsmitteln**
Rectangular parallelepiped housing for an electronic device with plug connections
Boîtier en forme d'un parallélépipède rectangle pour un dispositif électronique ayant des connexions à fiches

(30) Priorität: 29.01.1991 DE 9100962 U
(43) Veröffentlichungstag der Anmeldung: 05.08.1992
(73) Patentinhaber: VDO Adolf Schindling AG, 60326 Frankfurt/Main (DE)
(72) Erfinder: Hanke, Klaus-Dieter, Dipl.-Ing., W-7730 Villingen-Schwenningen (DE); Kastler, Ernst, W-7737 Bad Dürrheim 4 (DE); Hautvast, Heinz-Josef, Dipl.-Ing., W-7734 Brigachtal (DE)

(56) Entgegenhaltungen:
- EP-A- 0 323 579
- DE-U- 8 018 601
- US-A- 3 668 476

## Beschreibung

Die Erfindung betrifft ein quaderförmiges Gehäuse für eine elektronische Einrichtung mit Steckverbindungsmitteln für den Anschluß von Gebern und Peripheriegeräten zugeordneten Steckern, wobei die elektronische Einrichtung wenigstens zwei verschieden große, mit Abstand übereinander angeordnete Leiterplatten aufweist, von denen eine im wesentlichen den Abmessungen der Grundfläche des Gehäuses entspricht, die aus einer Richtung zugänglichen Steckverbindungsmittel sowohl der einen als auch der anderen Leiterplatte zugeordnet sind und die auf den Leiterplatten angeordneten Steckverbindungsmittel Kontaktzungen gleicher Länge darstellen.

Ein derartiges, gestuft ausgebildetes Gehäuse zeigt beispielsweise das DE-U 80 18 601. Die genannten elektronischen Einrichtungen stellen im allgemeinen Steuereinrichtungen dar, welche Mittel für die Spannungsversorgung und -regelung eines aus Gebern und Peripheriegeräten sowie einer Steuereinrichtung bestehenden Kontrollsystems, Mittel für die Geberabfrage und die Signalaufbereitung sowie Mittel für die Anzeige- und Aufzeichnungssteuerung umfassen. Solche Kontrollsysteme dienen der Störungsmeldung, der Anzeige und dem Aufzeichnen bzw. Speichern des Erreichens kritischer Betriebszustände oder des Erreichens von Reservewerten von Verbrauchsmedien bei Fahrzeugen, Maschinen oder Produktions- und Versorgungsanlagen.

Da ein derartiges Kontrollsystem eine Vielzahl von Leitungen und eine hohe Konzentration von Steckverbindungen an der Steuereinrichtung erforderlich macht, ist schon vorgeschlagen worden, bestimmten Gebergruppen, beispielsweise bestimmten Aggregaten zugeordneten Gebern, Schnittstellenschaltungen zuzuordnen, die der Geberabfrage und der Meßwert- bzw. Signalaufbereitung dienen und über eine geeignete Bus-Struktur mit einem Steuergerät und den übrigen Informations- und Datenerfassungsgeräten verknüpft sind.

Diese Lösung erfordert nicht nur einen erheblichen Programmaufwand bezüglich der Informationsverarbeitung sowie Installationsaufwand für die Schnittstellengeräte, je nach Anwendung werden auch tauch- und schwallwasserdichte sowie feldschirmende Gehäuse erforderlich.

Die technisch weniger aufwendige Lösung einer zentralen, beispielsweise in einem Fahrerhaus angeordneten Steuereinrichtung ist wegen verschiedener anderer Einrichtungen in der Regel mit Anordnungsschwierigkeiten und mit dem Problem behaftet, daß der zur Verfügung stehende Geräteraum verhältnismäßig eng begrenzt ist. Andererseits sind bei der für eine zentrale Steuereinrichtung erforderlichen Konzentration von elektronischen Bauelementen und von Steckverbindungen mit vorzugsweise unmittelbar dem Schaltungsträger zugeordneten Kontaktzungen für von einer Seite zugängliche Steckverbindungen Anfangsbedingungen gegeben, bei denen die Grundfläche bzw. die Anbringungsfläche des Gerätegehäuses kleiner ist als die erforderliche Bestückungsfläche einer Leiterplatte.

Es war somit die Aufgabe gestellt, ein Gehäuse zu schaffen, in welchem eine elektronische Einrichtung mit mehreren Steckverbindungen derart angeordnet werden kann, daß das betreffende Steuergerät durch eine optimale Raumnutzung vielseitig und von räumlichen Gegebenheiten weitgehend unabhängig anbringbar ist und sich durch einen einfachen, in der Fertigung gut reproduzierbaren und funktionssicheren Aufbau auszeichnet.

Die Lösung dieser Aufgabe sieht vor, daß das Gehäuse aus einem Boden und einer haubenartigen Abdeckung besteht, daß in der Abdeckung mehrere Steckerfassungen mit den Kontaktzungen zugeordneten Öffnungen ausgebildet sind, daß für den Zugang zu den der größeren Leiterplatte zugeordneten Steckerfassungen in der Abdeckung lediglich eine Nische ausgeformt ist und daß die Leiterplatten elektrisch miteinander kontaktiert sind.

Die gefundene Lösung bietet den Vorteil, unter Umständen vorhandene, relativ kleinflächige, aber leicht installierbare Gehäuseteile, beispielsweise einen Gehäuseboden für das zu schaffende Steuergerät, benutzen und neben in wenigstens zwei Ebenen angeordneten Leiterplatten hochbauende oder "stehend" anbringbare, elektrische Bauteile vorsehen zu können. Die Lösung, auf beiden Leiterplatten Kontaktzungen anzubringen, bietet den Vorteil, daß die Anzahl der Verbindungsleitungen zwischen den beiden Leiterplatten minimiert ist und somit auch die Funktionsrisiken durch interne Kontaktunterbrechungen reduziert sind. Sie bietet aber auch die Möglichkeit, die Elektronik so zu organisieren, daß auf der in der zweiten Ebene liegenden Leiterplatte die Ein- und Ausgänge solcher Geber vorgesehen sind, die nicht in allen Anwendungsfällen erforderlich sind, so daß diese Leiterplatte als eine weitgehend komplette Zusatzbaugruppe, die nachgerüstet werden kann, ausbildbar ist. Ein Beispiel hierfür sind Bremsbelagverschleißgeber und gegebenenfalls Bremsentemperaturgeber bei mit oder ohne Anhänger betreibbaren Nutzfahrzeugen.

Die Gehäuseform bzw. die Form der Abdeckung derart, daß sie der Lage der Leiterplatten angepaßt ist, bietet die Möglichkeit, daß auf beiden Leiterplatten gleiche Steckverbindungsmittel befestigt und diesen gleiche Steckerfassungen zugeordnet werden können.

In besonderer Weise platzsparend ist die Anordnung der verwendeten, mit jeweils einem federnden Riegel versehenen Stecker, indem die Riegel an der Außenseite des Gehäuses angreifen.

Im folgenden sei die Erfindung anhand der Zeichnungen näher erläutert.

Es zeigen
Fig. 1 einen Schnitt eines Ausführungsbeispiels der erfindungsgemäßen Anordnung,
Fig. 2 einen Schnitt des Ausführungsbeispiels quer zum Schnitt gemäß Fig. 1,

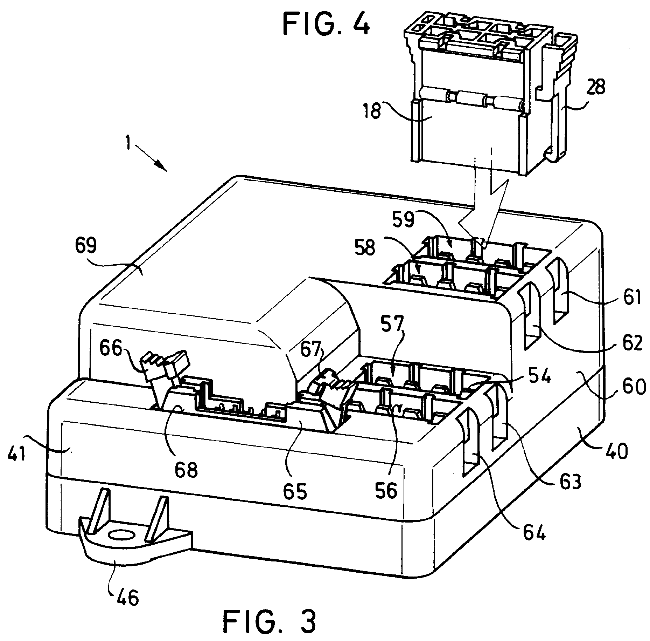

Fig. 3 eine perspektivische Darstellung des Ausführungsbeispiels,
Fig. 4 einen achtpoligen Stecker in einer funktionellen Zuordnung zu der in Fig. 3 dargestellten, elektronischen Einrichtung.

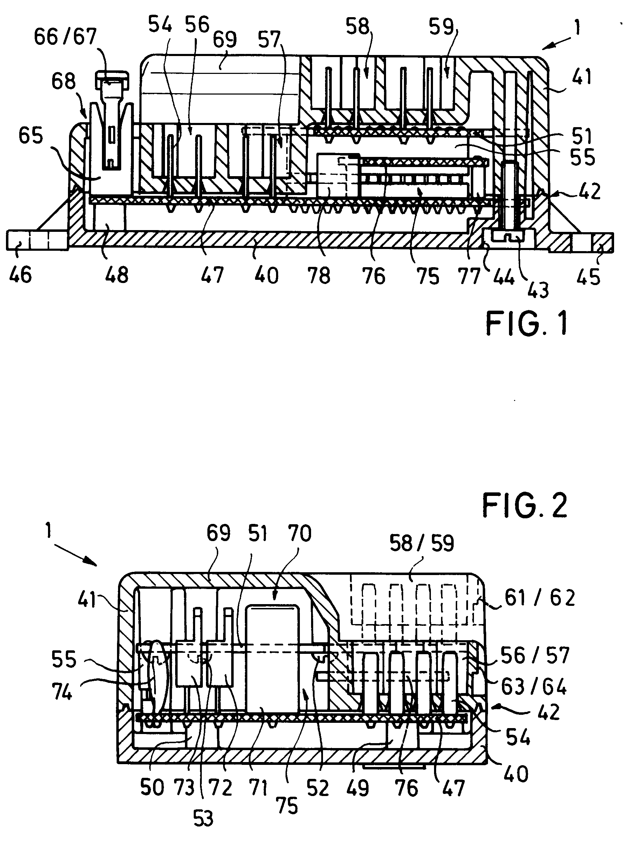

Bei dem in Fig. 1 dargestellten Ausführungsbeispiel wird das Gehäuse 1 von einem wannenförmigen Boden 40 und einer Abdeckung 41 gebildet. Beide Bauteile 40 und 41 sind unter Zwischenschaltung einer randlich ausgebildeten Nut-Steg-Verbindung 42 miteinander durch Schrauben verbunden, von denen in Fig. 1 eine - 43 - dargestellt ist. Mit 44 ist eine der Schraube 43 zugeordnete Plombensenkung bezeichnet. An dem Boden 40 angeformte Zungen 45 und 46 dienen der Befestigung des Gehäuses 1. Eine großflächige Leiterplatte 47 ist mittels nicht dargestellter Schrauben, die in am Boden 40 angeformten Auflagezapfen 48, 49, 50 eingreifen, mit dem Boden 40 fest verbunden. Eine kleinere Leiterplatte 51 ist mittels mehrerer Schrauben, von denen zwei mit 52 und 53 bezeichnet sind, mit der Abdeckung 41 verschraubt.

Beide Leiterplatten 47 und 51 sind mit gleichgestalteten Kontaktzungen 54 bestückt und über eine Stiftleisten-Verbindung 55 miteinander elektrisch verknüpft. Den Kontaktzungen 54 sind in der Abdeckung 41 ausgeformte Steckerfassungen 56, 57, 58 und 59 zugeordnet. Dabei sind für eine versenkte Anbringung der an den verwendeten Steckern 18 ausgebildeten Riegel 28 an einer Seitenwand 60 der Abdeckung 41 mit jeweils einem Hinterschnitt endende Nute 61, 62, 63 und 64 vorgesehen. Bei einem für ein Flachbandkabel vorgesehenen, nicht dargestellten Stecker ist der Steckersockel 65, an welchem dem Stecker zugeordnete Festhalteklauen 66 und 67 drehbar gelagert sind, unmittelbar auf der Leiterplatte 47 befestigt und ragt durch eine in der Abdeckung 41 ausgebildete Öffnung 68 aus dem Gehäuse 1 heraus.

Ferner ist die Abdeckung 41 bis auf die Bereiche, die für den Zugang zu den unmittelbar der Leiterplatte 47 zugeordneten Steckverbindungen freigespart sein müssen, im wesentlichen gleich hoch ausgebildet. Auf diese Weise ergibt sich ein durch einen Vorsprung 69 der Abdeckung 41 umbauter Raum 70, der sowohl durch die Leiterplatte 51, die L-förmig ausgebildet sein kann, als auch durch hochbauende, elektronische Bauelemente, beispielsweise einen Kondensator 71, Spannungsregler 72 und 73 sowie einen Varistor 74 nutzbar ist.

Aus den Fig. 1 und 2 ist außerdem noch ersichtlich, daß auch der Freiraum 75 zwischen den beidseitig bestückten Leiterplatten 47 und 51 durch Anordnen einer weiteren Leiterplatte 76, welche mittels geeigneter Stiftkontakte 77 sowohl mechanisch als auch elektrisch, beispielswiese mit der Leiterplatte 47 verbunden ist, genutzt ist. Mit 78 ist ein elektronisches Bauteil bezeichnet, das sich ebenfalls in dem Raum 75 befindet und in die Ebene, in der die Leiterplatte 76 angeordnet ist, hineinragt.

Die erfindungsgemäße Lösung zeigt, daß mit einer jeweiligen Zuordnung von im wesentlichen gleichgestalteten Stecker-Verbindungsmitteln zu ungleich großen, parallel zueinander angeordneten Leiterplatten bei in geeigneter Weise verschachtelter Anordnung von Leiterplatten und elektronischen Bauelementen zusätzlich eine Optimierung der Raumnutzung erzielbar ist.

## Patentansprüche

1. Quaderförmiges Gehäuse für eine elektronische Einrichtung mit Steckverbindungsmitteln (56, 57, 58, 59 und 54) für den Anschluß von Gebern und Peripheriegeräten zugeordneten Steckern (18), wobei die elektronische Einrichtung wenigstens zwei verschieden große, mit Abstand übereinander angeordnete Leiterplatten (47, 51) aufweist, von denen eine im wesentlichen den Abmessungen der Grundfläche des Gehäuses (1) entspricht, die aus einer Richtung zugänglichen Steckverbindungsmittel (56, 57, 58, 59 und 54) sowohl der einen als auch der anderen Leiterplatte (47, 51) zugeordnet sind und die auf den Leiterplatten (47, 51) angeordneten Steckverbindungsmittel Kontaktzungen (54) gleicher Länge darstellen,
**dadurch gekennzeichnet**,
daß das Gehäuse (1) aus einem Boden (40) und einer haubenartigen Abdeckung (41) besteht,
daß in der Abdeckung (41) mehrere Steckerfassungen (56, 57, 58, 59) mit den Kontaktzungen (54) zugeordneten Öffnungen ausgebildet sind,
daß für den Zugang zu den der größeren Leiterplatte (47) zugeordneten Steckerfassungen (56, 57) in der Abdeckung (41) lediglich eine Nische ausgeformt ist und daß die Leiterplatten (47, 51) elektrisch miteinander kontaktiert sind.

2. Quaderförmiges Gehäuse nach Anspruch 1,
**dadurch gekennzeichnet**,
daß die Steckerfassungen (56, 57, 58, 59) derart einer Seitenwand (60) des Gehäuses (1) zugeordnet sind, daß an den Steckern (18) quer zur Steckrichtung federnd ausgebildete Riegel (28) mit an der Außenseite der Seitenwand (60) ausgebildeten Vertiefungen (61, 62, 63, 64) zusammenwirken.

3. Quaderförmiges Gehäuse nach Anspruch 1,
**dadurch gekennzeichnet**,
daß die größere Leiterplatte (47) fest mit dem Boden (40) verbunden ist.

## Claims

1. A cuboid housing for an electronic device having plug-type connection means (56, 57, 58, 59 and 54) for the connection of plugs (18) associated with transmitters and peripheral devices, the electronic device having at least two printed circuit boards (47, 51) which are of different size, are arranged one above the other at a spacing and of which one corresponds substantially to the dimensions of the base board of the housing (1), the plug-type connection means (56, 57, 58, 59 and 54), which are accessible from one direction, being associated both with the one and with the other printed circuit board (47, 51) and the plug-type connection means arranged on the printed circuit boards (47, 51) providing contact strips (54) of the same length, characterized in that the housing (1) comprises a base (40) and a hood-type cover (41), in that a plurality of plug sockets (56, 57, 58, 59) having openings associated with the contact strips (54) are made in the cover (41), in that for access to the plug sockets (56, 57) in the cover (41), associated with the larger printed circuit board (47), there is merely formed a niche and in that the printed circuit boards (47, 51) are in electrical contact with one another.

2. A cuboid housing according to Claim 1, characterized in that the plug sockets (56, 57, 58, 59) are associated with a side wall (60) of the housing (1) such that latches (28) which are constructed on the plugs (18) such that they are resilient transversely with respect to the direction of plugging in cooperate with depressions (61, 62, 63, 64) made on the outer side of the side wall (60).

3. A cuboid housing according to Claim 1, characterized in that the larger printed circuit board (47) is fixedly connected to the base (40).

## Revendications

1. Boîtier parallélépipédique pour un dispositif électronique avec des moyens de connexion enfichables (56, 57, 58, 59 et 54) pour le raccordement de connecteurs (18) associés à des transmetteurs et appareils périphériques, ledit dispositif électronique présentant au moins deux platines à circuits imprimés (47, 51) de tailles différentes, disposées à distance l'une au-dessus de l'autre, dont l'une correspond, pour l'essentiel, aux dimensions de la surface de base dudit boîtier (1), les moyens de connexion enfichables (56, 57, 58, 59 et 54) accessibles dans un sens étant associés aussi bien à l'une qu'à l'autre desdites platines à circuits imprimés (47, 51) et lesdits moyens de connexion enfichables disposés sur lesdites platines à circuits imprimés (47, 51) représentant des languettes de contact (54) d'égales longueurs,
caractérisé par le fait
que ledit boîtier (1) est constitué d'un fond (40) et d'un recouvrement (41) en forme de capot,
que dans ledit recouvrement (41) sont moulées plusieurs douilles de connecteur (56, 57, 58, 59) avec des ouvertures associées auxdites languettes de contact (54), que, pour permettre l'accès aux douilles de connecteur (56, 57) associées à la plus grande (47) des platines à circuits imprimés, on a seulement moulé une niche dans le recouvrement (41) et que les platines à circuits imprimés (47, 51) ont été électriquement mises en contact l'une avec l'autre.

2. Boîtier parallélépipédique selon la revendication 1,
caractérisé par le fait
que les douilles de connecteur (56, 57, 58, 59) sont associées à une paroi latérale (60) du boîtier (1) de telle sorte que des verrous élastiques (28) formés sur les connecteurs (18) transversalement au sens d'enfichage coopèrent avec des cavités (61, 62, 63, 64) formées sur la face extérieure de la paroi latérale (60).

3. Boîtier parallélépipédique selon la revendication 1,
caractérisé par le fait
que la plus grande des platines à circuits imprimés (47) est rigidement reliée au fond (40).
